(19) Europäisches Patentamt
European Patent Office
Office européen des brevets

(11) EP 2 819 183 B1

(12) **EUROPEAN PATENT SPECIFICATION**

(45) Date of publication and mention of the grant of the patent:
**26.09.2018 Bulletin 2018/39**

(21) Application number: **13751177.0**

(22) Date of filing: **08.02.2013**

(51) Int Cl.:
***H01L 33/08*** *(2010.01)* ***H01L 33/10*** *(2010.01)*
*H01S 5/183* *(2006.01)*

(86) International application number:
**PCT/JP2013/053083**

(87) International publication number:
**WO 2013/125376 (29.08.2013 Gazette 2013/35)**

(54) **SEMICONDUCTOR LIGHT-EMITTING ELEMENT**

LICHTEMITTIERENDES HALBLEITERELEMENT

ÉLÉMENT ÉLECTROLUMINESCENT SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.02.2012 JP 2012035075**

(43) Date of publication of application:
**31.12.2014 Bulletin 2015/01**

(73) Proprietor: **FUJIFILM Corporation**
**Tokyo 106-8620 (JP)**

(72) Inventors:
- **HAKUTA Shinya**
  **Ashigarakami-gun**
  **Kanagawa 258-8577 (JP)**
- **SONODA Shinichiro**
  **Ashigarakami-gun**
  **Kanagawa 258-8577 (JP)**

(74) Representative: **Klunker IP**
**Patentanwälte PartG mbB**
**Destouchesstraße 68**
**80796 München (DE)**

(56) References cited:
**JP-A- 2000 299 493**
**JP-A- 2002 204 026**
**JP-A- 2009 070 929**
**US-A1- 2002 071 463**
**US-A1- 2007 128 743**
**US-A1- 2010 224 892**
**US-B1- 6 546 038**

- **ZHANG JIANG-YONG ET AL: "Low threshold lasing of GaN-based vertical cavity surface emitting lasers with an asymmetric coupled quantum well active region", APPLIED PHYSICS LETTERS, AMERICAN INSTITUTE OF PHYSICS, US, vol. 93, no. 19, 14 November 2008 (2008-11-14), pages 191118-191118, XP012112266, ISSN: 0003-6951, DOI: 10.1063/1.3030876**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 819 183 B1

Printed by Jouve, 75001 PARIS (FR)

## Description

## BACKGROUND OF THE INVENTION

1. Field of the Invention

The present invention relates to a surface emission-type semiconductor light-emitting element including distributed Bragg reflectors and active layers which are sequentially grown on a semiconductor substrate.

2. Description of the Related Art

Zhang et al., "Low threshold lasing of GaN-based vertical cavity surface emitting lasers with an asymmetric coupled quantum well active region", in applied physics letter 93, 191118 (2008) teaches GaN-based vertical cavity surface emitting lasers with a unique active region structure. Document US2010224892 A1 discloses a nitride semiconductor light emitting element including an n side anti-reflection layer and a p side Bragg reflection layer formed so as to sandwich an MQW active layer that serves as a light emitting region.

Semiconductor light-emitting elements such as a light-emitting diode (LED) or a laser diode (LD) are sometimes configured to include distributed Bragg reflectors (DBRs) in order to increase emission efficiency (JP1994-196681A (JP-H6-196681A) and JP2009-70929A, and the like). In a case of surface emission-type semiconductor light-emitting elements, DBRs provided in upper and lower layers of a light-emitting layer are generally configured to strengthen resonance, and contribute to an increase in emission efficiency by enhancing the reflectance of a specific wavelength. The DBR is constituted by a multilayer film in which a layer having a relatively high refractive index (high refractive index layer) and a layer having a relatively low refractive index (low refractive index layer) are alternately laminated, and the reflection wavelength of the DBR is very sensitive to the thicknesses of films constituting the DBR. Therefore, the emission efficiency of the semiconductor light-emitting element including the DBR also undergoes a great change in emitted light intensity (emission efficiency) during a shift in emission wavelength. That is, the magnitudes of an increase in emission efficiency caused by the DBR and a change in emission efficiency caused by a shift in wavelength have a tradeoff relation.

On the other hand, it is known that in the emission spectrum of the semiconductor light-emitting element, a great change in environmental temperature occurs and that an increase in temperature causes a shift of emission wavelength to the long wavelength side. For example, in a GaAs-AlAs-based LED, when the temperature of usage environment rises by approximately 40°C, a wavelength shifts by approximately 10 nm to the long wavelength side. For this reason, in the semiconductor light-emitting element including the DBR, there is a problem in that emitted light intensity changes significantly due to a change in environmental temperature.

JP2009-70929A and JP2003-332615A, and the like propose a method of solving such a problem of a fluctuation in emission efficiency due to a change in environmental temperature.

JP2009-70929A proposes an element structure in which a plurality of multilayer film reflective layers that reflect beams of light on the long wavelength side and the short wavelength side of a light spectrum generated from an active layer are provided below the active layer, to thereby reduce the influence of a wavelength shift due to a change in environmental temperature, effectively using the light spectrum as a wide band.

In addition, JP2003-332615A proposes an element structure in which a notch filter constituted by a first multilayer film layer, a second multilayer film layer, and a spacer layer interposed between two multilayer films is included on an upper layer of an active layer, to thereby reduce the influence of a wavelength shift due to a change in environmental temperature.

On the other hand, an exposure apparatus in which a plurality of semiconductor light-emitting elements are arranged one-dimensionally or two-dimensionally is used in an exposure head of a printer, a scanner or the like. In such an array-like exposure apparatus, the uniformity of light intensity is obtained between the plurality of semiconductor light-emitting elements arranged. Here, the light intensity refers to the intensity of light integrated over the emission wavelength band of the light-emitting element.

Even in the plurality of semiconductor light-emitting elements used in the exposure apparatus, the light intensity of the individual semiconductor light-emitting element changes according to a wavelength shift due to a change in environmental temperature. Further, a phenomenon that the way of a change in light intensity is different for each element is visible. For this reason, there is a problem in that the uniformity of light intensity between the plurality of semiconductor light-emitting elements used in the exposure apparatus is not maintained due to a change in environmental temperature.

JP2010-219220A proposes a light-emitting device in which a reflective layer is included in a lower layer with an active layer interposed therebetween, and a surface having unevenness at plural distances from the reflective layer is included in an upper layer, to thereby suppress a temperature change in the light intensity of a light-emitting element.

## SUMMARY OF THE INVENTION

Generally, a semiconductor light-emitting element is obtained by the lamination of each layer on a wafer followed by separation into a large number of chips, and a large number of semiconductor light-emitting elements are manufactured from one wafer. It is ideal that the thickness of a laminated film formed on a wafer is uniform on one surface of the wafer according to a design value. However, in reality, a uniform film is not likely to be formed, and thus a variation occurs in film thickness. As a result, portions having a slightly small or large film thickness from a design value occur in one wafer. When the wafer is separated into a large number of chips, a variation thus occurs in film thickness for each chip. Basically, as the film thickness shifts in a direction in which the entire DBR is reduced in thickness, a reflection wavelength shifts to the short wavelength side. It is considered that a variation in the reflection wavelength of the DBR due to such a variation in film thickness gives rise to a difference in emitted light intensity to an emission wavelength, and that a phenomenon of a change in light intensity due to a change in environmental temperature being different for each chip is caused.

The present invention is contrived in view of such circumstances, and an object thereof is to provide a semiconductor light-emitting element which is capable of suppressing a change in light intensity toward a spectrum shift due to a shift in film thickness during film formation or a change in environmental temperature while obtaining the effect of an increase in light intensity caused by a DBR, and capable of suppressing a variation in light intensity between elements simultaneously manufactured from one wafer.

According to the present invention, there is provided a semiconductor light-emitting element that outputs emitted light having a predetermined emission peak wavelength, including at least: a substrate; a lower distributed Bragg reflective layer provided on the substrate; and a light-emitting layer provided on the lower distributed Bragg reflective layer, wherein the light-emitting layer has a structure in which one or more sets of two active layers arranged at a distance of (1+2m) $\lambda/4n$ with a variation of $\pm$ 10 % are included in an inactive layer, $\lambda$ is the emission peak wavelength, n is a refractive index of the light-emitting layer, and m is an integer of 0 or greater, wherein the distance between two active layers is defined by a mutual distance between their centres in a thickness direction, and wherein an antireflective layer for the emitted light is included on the light-emitting layer. Further preferred embodiments of the invention are defined in the dependent claims.

The term "on the light-emitting layer" as used herein means a layer located above the light-emitting layer, and is not limited to lamination in contact with the light-emitting layer.

In addition, in the semiconductor light-emitting element of the present invention, at least one phase change layer having a thickness of $j\cdot\lambda/2n$ may be included in the lower distributed Bragg reflective layer, n is a refractive index of the phase change layer, and j is an integer of 1 or greater.

Meanwhile, the definition of each thickness is assumed to include a range of $\pm$10%. For example, a thickness of (1+2m) $\lambda/4n$ means that the thickness may be in a range of $(1+2m)\lambda/4n\times0.9$ to $(1+2m)\lambda/4n\times1.1$.

The semiconductor light-emitting element of the present invention that outputs emitted light having a predetermined emission peak wavelength according to claim 1 allows a change in emitted light intensity when environmental temperature changes to be suppressed with almost no change in the sum of the emitted light intensities from two active layers even when a wavelength shift occurs.

Therefore, it is possible to suppress a change in light intensity toward a spectrum shift due to a shift in film thickness during film formation or a change in environmental temperature while obtaining the effect of an increase in light intensity caused by a DBR, and to suppress a variation in light intensity between elements simultaneously manufactured from one wafer.

## BRIEF DESCRIPTION OF THE DRAWINGS

Fig. 1A is a schematic cross-sectional view and a partially enlarged view illustrating a semiconductor light-emitting element according to an embodiment.

Fig. 1B is a schematic cross-sectional view illustrating the semiconductor light-emitting element of a design change example of the embodiment.

Fig. 2 is a diagram illustrating a spectrum of spontaneously emitted light.

Fig. 3 is a cross-sectional view and a plan view schematically illustrating a variation of film thickness when film formation on a wafer is performed.

Fig. 4 is a diagram illustrating an LED layer configuration of Simulation 1.

Fig. 5 is a graph illustrating dependency of average emission magnification and a variation in temperature characteristics on a distance between two active layers.

Figs. 6A to 6C are graphs illustrating a resonator spectrum when two active layers are included.

Fig. 7 is a diagram illustrating insertion positions of two active layers which are separated from each other at a distance of λ/4n within a light-emitting layer.

Fig. 8 is a graph illustrating dependency of average emission magnification and a variation in temperature characteristics on an active layer position.

Fig. 9 is a schematic cross-sectional view illustrating a light-emitting layer having a thickness of λ/n in Simulation 3.

Fig. 10 is a schematic cross-sectional view illustrating a light-emitting layer having a thickness of 3λ/2n in Simulation 3.

Fig. 11 is a schematic cross-sectional view illustrating a light-emitting layer having a thickness of 2λ/n in Simulation 3.

Fig. 12 is a schematic cross-sectional view illustrating a light-emitting layer in Simulation 4.

Fig. 13 is a schematic cross-sectional view illustrating a light-emitting layer in Simulation 5.

Fig. 14 is a diagram illustrating a layer configuration of an LED according to Example 1.

Fig. 15 is a diagram illustrating a layer configuration of an LED according to Comparative Example 1, which is not covered by the claims.

Fig. 16 is a diagram illustrating a layer configuration of an LED according to Comparative Example 2, which is not covered by the claims.

Fig. 17 is a diagram illustrating a layer configuration of an LED according to a reference example, which is not covered by the claims.

Fig. 18 is a diagram illustrating a layer configuration of an LED according to Example 2.

## DESCRIPTION OF THE PREFERRED EMBODIMENTS

Hereinafter, an embodiment of a semiconductor light-emitting element of the present invention will be described with reference to the accompanying drawings.

Fig. 1A is a schematic cross-sectional view and a partially enlarged view illustrating a semiconductor light-emitting element 1 according to an embodiment of the present invention.

The semiconductor light-emitting element 1 is a surface emission-type semiconductor light-emitting element including a lower distributed Bragg reflective layer 12 (hereinafter, referred to as the lower DBR layer 12), a p-type doped layer 13, a light-emitting layer 20, an n-type doped layer 15, an upper distributed Bragg reflective layer 16 (hereinafter, referred to as the upper DBR 16), a contact layer 17 and an antireflective layer 18, on a p-type substrate 10. As in a light path of emitted light L schematically illustrated by arrows in the drawing, light generated in the light-emitting layer 20 is reflected between the lower DBR layer 12 and the upper DBR layer 16, and passes through the upper DBR layer 16, which leads to surface emission.

The composition of each layer is not particularly limited, and, for example, p-type GaAs can be used as the substrate 10, an AlGaAs-based semiconductor multilayer film can be used as the lower DBR layer 12 and the upper DBR layer 16, p-type AlGaAs can be used as the p-type doped layer 13, AlGaAs can be used as the light-emitting layer 20, n-type AlGaAs can be used as the n-type doped layer 15, n-type GaAs can be used as the contact layer 17, and $SiO_X$ or $SiN_X$ can be used as the antireflective layer 18. Meanwhile, an AlGaAs-based semiconductor layer can be configured as each functional layer by changing the ratio of Al to Ga.

As shown by the partially enlarged view of Fig. 1A, the light-emitting layer 20 includes two active layers 22 arranged between inactive layers 21 at a distance of (1+2m) λ/4n (here, m is an integer of 0 or greater, n is a refractive index of the light-emitting layer, and λ is an emission peak wavelength) with respect to each other. Here, the distance between two layers is defined by a mutual distance between the centres in a thickness direction. Here, the light-emitting layer 20 has a structure in which the inactive layer 21 and the active layer 22 are alternately arranged.

Meanwhile, in a process of forming each layer when the semiconductor light-emitting element is manufactured, error of a maximum of approximately ±10% from a design value can occur in film thickness. Therefore, each film thickness in the specification is assumed to allow ±10% for thickness error.

Both the lower DBR layer 12 and the upper DBR layer 16 are multilayer films in which a high refractive index layer having a relatively high refractive index and a low refractive index layer having a relatively low refractive index are alternately laminated. The basic structure of a general DBR layer is a multilayer film structure in which two or more sets of (four or more layers in total) a pair of the low refractive index layer and the high refractive index layer are included, and is configured to efficiently reflect light having an emission wavelength region. Each thickness of the low refractive index layer and the high refractive index layer is generally in the vicinity of λ/4n (here, λ is a desired reflection center wavelength, and n is a refractive index of each layer).

Generally, the element having the above-mentioned configuration is manufactured by each layer being sequentially formed on a wafer using a film formation method such as a MOCVD method and then being formed into a chip. It is ideal that each semiconductor film be formed to have a uniform film thickness during film formation on a wafer, but a variation in thickness occurs on a wafer in reality. There are a variety of such variations in thickness depending on the types of materials or film formation methods, and a variation of approximately ±10% may occur. As described earlier, since the DBR is very sensitive to film thickness, the variation in film thickness on a wafer causes the generation of a variation in temperature characteristics for each element formed into a chip. However, according to the element having the configuration of the present embodiment, even when a variation in film thickness occurs during manufacturing, it is possible to manufacture a device in which a variation in temperature characteristics is considerably suppressed between a plurality of elements obtained from one wafer, while maintaining a light intensity increase effect caused by the DBR.

The arrangement of two active layers spaced from each other by a distance of (1+2m) λ/4n establishes a relation in which an increase in emission from one active layer leads to a decrease in emission from the other active layer when a shift in emission wavelength occurs due to a change in temperature, and the sum of emissions in the two layers exhibits little change even when a shift in wavelength occurs. For this reason, it is considered to be able to realize a semiconductor light-emitting element having little change in characteristics with respect to a shift in wavelength.

As shown in Fig. 1A, the semiconductor light-emitting element of the present embodiment is configured such that two active layers 22 are arranged at positions symmetric with respect to a central position A of the light-emitting layer 20 in a thickness direction. The arrangement of the active layers may not necessarily be symmetric with respect to A, but is most likely to exhibit an effect by arranging the active layers at symmetric positions (see Simulation 2 described later).

Here, m is an integer of 0 or greater, but an increase in m necessitates an increase in the thickness of the entire light-emitting layer. As a result, a rise in manufacturing costs is caused, and thus a relation of m=O is most preferable.

In addition, it is preferable that the thickness of the entire light-emitting layer 20 be kλ/2n (here, k is an integer of 1 or greater, and n is a refractive index of the light-emitting layer). As shown in Simulation 1 described later, the degree of density of light intensity distribution within the light-emitting layer is appropriately controlled, thereby allowing an effect to be enhanced. The thickness of the light-emitting layer is adjusted to kλ/2n, thereby allowing the light intensity distribution formed within the light-emitting layer by upper and lower DBRs to be set to have a centrosymmetric shape, which leads to an easy combination of the active layers with position control.

In addition, plural sets of two active layers arranged at a distance of (1+2m)λ/4n are provided in inactive layers (see Simulation 3 described later).

Particularly, each active layer is formed as a quantum well active layer having a thickness of equal to or less than 10 nm, and a large number of quantum well active layers are included in the light-emitting layer. With such a configuration, the thickness of each active layer can be made more uniform, and the active layer is formed as a thin quantum well. Therefore, a phenomenon, in which emitted light intensities at the interface and the center estimated when the active layer is thick are different from each other, is not likely to occur, and thus uniform emission is possible in the entire inside of the active layer, resulting in a preferable result (see Simulation 5 and Example 2 described later).

Meanwhile, when the semiconductor light-emitting element is an LED, there is a concern that an excessive reduction in the total thickness of the active layers may give rise to carrier saturation, and thus it is preferable that the total thickness of the active layers in the light-emitting layer be equal to or greater than λ/4n (see reference example described later).

Fig. 1B is a schematic cross-sectional view illustrating a semiconductor light-emitting element according to a design change example of the above embodiment. In the design change example, the structure of a lower DBR layer is different from that in the above embodiment, and a phase change layer 33 having a thickness of jλ/2n is included in a lower DBR layer 30 (λ is an emission peak wavelength, n is a refractive index of the phase change layer, and j is an integer of 1 or greater). In addition, an upper DBR layer is not included therein.

As described earlier, the basic structure of a general DBR layer is a multilayer film structure in which two or more sets of (four or more layers in total) a pair of low refractive index layer 31 having a thickness a and high refractive index layer 32 having a thickness b are included, and is configured to efficiently reflect light having an emission wavelength region. However, in the present embodiment, the phase change layer 33 having a thickness of jλ/2n is included in the lower DBR layer 30. With such a configuration of the lower DBR layer, it is possible to effectively suppress a variation in temperature characteristics. Only one phase change layer may be provided, but it is more preferable that two layers be provided. When two phase change layers are arranged in the lower DBR layer, it is preferable that a first phase change layer be arranged in a pair closest to the light-emitting layer 20.

Meanwhile, any one layer or two layers of the low refractive index layer 31 and the high refractive index layer 32, constituting the lower DBR layer 30, which are alternately arranged can be provided with the phase change layer 33 by setting the thickness thereof to be jλ/2n. Meanwhile, j may be 2 or greater, but an effect does not change much as compared with a case where j is 1. On the other hand, since an increase in layer thickness leads to a rise in formation costs, it is most preferable that j be 1, that is, the thickness of the phase change layer 33 be λ/2n.

Meanwhile, even when the lower DBR layer according to the design change example shown in Fig. 1B is provided, the upper DBR layer may be provided.

Hereinafter, simulations will be described which leads to the finding of the configuration of the present invention for suppressing the temperature change (temperature characteristics) of the light intensity of the semiconductor light-emitting element due to a change in surrounding environmental temperature and a variation in film thickness on manufacturing, while maintaining an emitted light intensity enhancement effect caused by the DBR layer.

<Simulation Method>

First, a simulation method will be described.

The following examination was performed on a GaAs-AlAs-based light-emitting element having an emission peak wavelength of 780 nm at room temperature. Fig. 2 shows a spontaneous emission spectrum of the GaAs-AlAs-based light-emitting element used herein. When a temperature rises from room temperature by approximately 40°C, the spontaneous emission spectrum is assumed to shift by 10 nm to the long wavelength side (shown by a broken line in Fig. 2). The spontaneous emission spectrum refers to a spectrum of light emitted from the light-emitting layer, and is a spectrum which is not influenced by the DBR.

When film formation is performed in reality, there are a variety of variations in thickness on a wafer depending on the types of materials or film formation methods, and a variation in thickness of a maximum of approximately ±10.0% may occur. On the other hand, the variation in thickness can be suppressed to approximately ±2.5% through research or the like on film formation conditions and target materials. Consequently, in the following simulation, a variation in thickness is assumed to be ±2.5%.

As shown by a schematic cross-sectional view in Fig. 3, assuming that there are five elements, having different film thicknesses in a range of ±25%, which are formed on one wafer, variations in temperature characteristics, and average emission magnifications were obtained by a simulation, and the LED structure was evaluated on the basis thereof. As five elements having different film thicknesses, element 1 which was 2.50% less than a reference thickness, element 2 which was 1.25% less than the reference thickness, element 3 having the reference thickness, element 4 which was 1.25% larger than the reference thickness, and element 5 which was 2.50% larger than the reference thickness were assumed which correspond to positions 1 to 5 schematically shown in the plan view of Fig. 3.

The variations in temperature characteristics were obtained as follows.

First, a resonator spectrum Ri(λ) is obtained from each element structure (i is an element number, where i=1,2,3,4,5, and the same is true of the following).

The resonator spectrum is a spectrum of light which is output from the element when light having the same intensity at all the wavelengths is emitted from the light-emitting layer, and is determined to be independent of the emission spectrum of the light-emitting layer. Here, the resonator spectrum was obtained by a simulation using the internal emission calculation of a multilayer film in which absorption is performed. Specifically, the multilayer film calculation of external incidence was performed with reference to "Basic Theory of Optical Thin Films" (authored by Mitsunobu Kobiyama, Optronics Corporation) or the like, and internal emission was calculated by separately calculating a phase difference within the light-emitting layer. Meanwhile, a similar calculation can also be reproduced by internal emission calculation software such as SETFOS made by FLUXiM AG

Next, the resonator spectrum Ri(λ) is multiplied by spontaneous emission spectrum S(λ), and the resultant is integrated with respect to a wavelength. Emitted light intensity Pi (i=1, 2, 3, 4, and 5) is then obtained with respect to each element.

$$Pi \propto \int (S(\lambda) \times Ri(\lambda)) d\lambda$$

When environmental temperature rises by 40°C, a spontaneous emission spectrum at room temperature is assumed to shift by 10 nm to the long wavelength side as it is, and emitted light intensity Pi' is obtained with respect to each element, using the spectrum S'(λ) shifting by 10 nm to the long wavelength side.

$$S'(\lambda) = S(\lambda - 10\ \mathrm{nm})$$

$$Pi' \propto \int (S'(\lambda) \times Ri(\lambda)) d\lambda$$

Next, a difference between Pi and Pi' is taken, and the amount of change of emitted light intensity with respect to temperature is obtained. Here, since the amount of change corresponds to a change in environmental temperature of 40°C, a light intensity change (unit: /°C) per 1°C is obtained therefrom.

$$dPi/dT=(Pi'-Pi)/40$$

2) In this manner, light intensity change dPi/dT (i=1, 2, 3, 4, and 5) per unit temperature is obtained with respect to each of five elements 1 to 5, and a maximum value (Max (dPi/dT)) and a minimum value (Min (dPi/dT)) among them are extracted. A difference between the maximum value and the minimum value is set to a variation temperature characteristics (variation in temperature characteristics) δ.

$$\delta=Max(dPi/dT)-Min(dPi/dT)$$

An average emission magnification caused by the DBR layer was obtained as follows.

An emitted light intensity $P_0$ when the DBR layer is not included is obtained, emission magnification $Pi/P_0$ for each element is obtained, and the average value of emission magnification for five elements is set to an average emission magnification M. Meanwhile, in the following, the average emission magnification may be simply referred to as emission magnification.

$$P_0 \propto \int(S(\lambda))d\lambda$$

$$Pi/P_0=\int(S(\lambda)\times Ri(\lambda))d\lambda/\int(S(\lambda))d\lambda$$

$$M=[\Sigma Pi/P_0]/5$$

The element used in the following simulation is an element including a lower DBR layer, an AlGaAs-based light-emitting layer, and an upper DBR layer, using a GaAs substrate. The DBR layer is constituted by a multilayer film in which $Al_{0.3}Ga_{0.7}As$ having a relatively high refractive index and $Al_{0.9}Ga_{0.1}As$ having a relatively low refractive index are alternately laminated. Meanwhile, in the DBR layer, the pair of high refractive index layer and low refractive index layer is counted as one layer.

<Simulation 1>

Here, an LED having a layer configuration shown in a table of Fig. 4 was examined. Meanwhile, in the table of Fig. 4, an $Al_xGa_{1-x}As$ layer is shown by numerical value x×1000 continuous to Al. For example, Al900 shows an $Al_{0.9}Ga_{0.1}As$ low refractive index layer, and Al300 shows an $Al_{0.3}Ga_{0.7}As$ high refractive index layer.

The upper DBR layer 16 of 4.5 layers is included on the upper layer (air side), and the lower DBR layer 12 of 10 layers is included in on the lower side (substrate 10 side). The thickness of the light-emitting layer (active) 20 is 108 nm, and is equivalent to a thickness of λ/2n with respect to a center wavelength of 780 nm of a spontaneous emission spectrum.

As shown by an enlarged schematic diagram in Fig. 4, the light-emitting layer 20 is configured such that two active layers 22 that emit light are provided in the inactive layers 21 that do not emit light. The thickness of each active layer 22 was set to 3 nm.

In this simulation, two active layers 22 within the light-emitting layer 20 were arranged at positions symmetric to each other with respect to a central position A of the light-emitting layer 20 in a thickness direction. A distance between active layers (distance between the centers of two active layers) shown in Fig. 4 was set to d, and a change in LED characteristics was inspected by changing d between 0 and 100 nm. Here, the relation of d=0 refers to a state where two active layers 22 completely overlap each other at the central position A.

A variation in temperature characteristics δ and average emission magnification M for the element having the configuration were obtained according to the above simulation method. The results are shown in Table 1.

[Table 1]

| Distance between two layers (nm) | 0 | 4 | 12 | 20 | 28 | 36 |
|---|---|---|---|---|---|---|
| Average emission magnification M | 1.671 | 1.668 | 1.649 | 1.610 | 1.555 | 1.487 |
| Variation in temperature characteristics δ (%/°C) | 1.200 | 1.194 | 1.147 | 1.051 | 0.906 | 0.710 |

| Distance between two layers (nm) | 40 | 44 | 46 | 48 | 50 | 52 |
|---|---|---|---|---|---|---|
| Average emission magnification M | 1.449 | 1.409 | 1.388 | 1.367 | 1.346 | 1.325 |
| Variation in temperature characteristics δ (%/°C) | 0.592 | 0.462 | 0.392 | 0.319 | 0.243 | 0.164 |

| Distance between two layers (nm) | 54 | 56 | 58 | 60 | 64 | 68 |
|---|---|---|---|---|---|---|
| Average emission magnification M | 1.304 | 1.282 | 1.261 | 1.240 | 1.199 | 1.159 |
| Variation in temperature characteristics δ (%/°C) | 0.145 | 0.180 | 0.236 | 0.335 | 0.541 | 0.754 |

| Distance between two layers (nm) | 76 | 84 | 92 | 100 |
|---|---|---|---|---|
| Average emission magnification M | 1.087 | 1.026 | 0.981 | 0.954 |
| Variation in temperature characteristics δ (%/°C) | 1.189 | 1.604 | 1.954 | 2.194 |

Regarding Table 1, Fig. 5 shows a graph in which a horizontal axis represents a distance between two layers d, and a vertical axis represents average emission magnification and a variation in temperature characteristics. As shown in Fig. 5, the average emission magnification becomes larger as the distance between two layers d becomes smaller. That is, the average emission magnification becomes larger as two active layers come closer to each other, and the positions thereof are nearer to the central portion of the light-emitting layer.

On the other hand, it is known that the variation in temperature characteristics has a minimum value when d=54 nm. Here, d=54 nm is equivalent to a thickness of λ/4n with respect to λ=780 nm which is an emission wavelength. It was made clear that when d=54 nm, the average emission magnification was approximately 1.3 times, and that both an enhancement effect and a suppression effect of a variation in temperature characteristics was able to be achieved. That is, in a structure in which two active layers are included in the light-emitting layer by this simulation, it was made clear that the variation in temperature characteristics was able to be minimized while maintaining the enhancement effect of emitted light intensity when the distance between active layers d was λ/4n.

A reason for d=λ/4n being desirable was examined.

Figs. 6A to 6C show a resonator spectrum (Fig. 6A) when only an upper active layer (=active layer closer to the air side) emits light, a resonator spectrum (Fig. 6B) when only a lower active layer (=substrate side) emits light, and a resonator spectrum (Fig. 6C) at upper and lower average emission, respectively.

A wavelength on a long wavelength side is strongly enhanced, as shown in Fig. 6A, when only the upper active layer emits light, and a wavelength on the short wavelength side is strongly enhanced, as shown in Fig. 6B, when only the lower active layer emits light. As shown in Fig. 6C, the entire resonator spectrum which is an average of these wavelengths shows a relatively gentle spectrum at the entire wavelength.

The DBR reflects light due to strong interference. When the DBRs are present at the upper and lower portions, beams of light manufactured by the DBRs interfere with each other and thus the great intensity level and intensity distribution of light occur. In order to prevent the carrier saturation of an LED, the thickness of the light-emitting layer is set to 108 nm in this examination. Since such a thickness is equivalent to λ/2n, the degree of density of light occurs within the light-emitting layer due to the DBR. Further, since the spontaneous emission spectrum of the LED is wide, the intensity distribution of light occurs at a different position due to an emission wavelength. For this reason, when only one specific place within the light-emitting layer serves as an active layer and light is emitted, a specific wavelength is strongly enhanced as in the resonator spectrum on only the upper side in Fig. 6A or the lower side in Fig. 6B. In this case, light intensity changes significantly due to a wavelength shift depending on the temperature of the spontaneous emission spectrum, and thus the variation in temperature characteristics also increases as a result.

On the other hand, it is considered that it is possible to alleviate the enhancement of only a specific wavelength by providing two active layers at a predetermined interval, and to cause the entire spontaneous emission spectrum to have the same resonator spectrum intensity. Regarding the light-emitting layer having a thickness of (λ/2n), the emission intensities of a reference wavelength from two active layers with a distance of (λ/4n) being maintained are substantially equal to each other. In cases of the longer wavelength side and the shorter wavelength side than the reference wavelength, an increase in the light intensity of one active layer leads to a decrease in the light intensity of the other active layer, the light intensity as a whole is maintained substantially uniform. When a distance between two active layers is maintained to be (λ/4n), absolute values of an increase and decrease in this light intensity are closest to each other. Therefore, it is considered that the effect of maintaining average light intensity is largest, which results in an advantage.

<Simulation 2>

It was made clear by the examination of Simulation 1 that it was important to maintain a distance between the active layers within the light-emitting layer to be (λ/4n). Next, as shown in Fig. 7, a simulation was performed on a case in which the positions of the active layers within the light-emitting layer are displaced in a state where an interlayer distance is maintained.

The LED was configured to have substantially the same structure as that in Simulation 1, and to move the positions of the active layers within the light-emitting layer. The position of one active layer 22 was changed between 0 nm and 54 nm when seen from the opposite side to the substrate within the light-emitting layer, and the variation in temperature characteristics δ and the emission magnification M at each position were obtained according to the above-mentioned simulation method. The other active layer 22 was arranged at a position obtained by adding up the position of the upper active layer to 54 nm, and the position within the light-emitting layer was changed while maintaining the distance between two active layers d to be 54 nm (=λ/4n).

The variation in temperature characteristics δ and the average emission magnification M which are obtained for each active layer position are shown in Table 2.

[Table 2]

| Position of upper active layer (nm) | 0 | 3 | 7 | 11 | 15 | 19 |
|---|---|---|---|---|---|---|
| Average emission magnification M | 1.3483 | 1.3468 | 1.343 | 1.3374 | 1.3303 | 1.322 |
| Variation in temperature characteristics δ (%/° C) | 0.1911 | 0.183 | 0.1728 | 0.1636 | 0.1558 | 0.1499 |

| Position of upper active layer (nm) | 23 | 27 | 31 | 35 | 39 | 43 |
|---|---|---|---|---|---|---|
| Average emission magnification M | 1.3129 | 1.3036 | 1.295 | 1.2862 | 1.2790 | 1.274 |
| Variation in temperature characteristics δ (%/° C) | 0.146 | 0.145 | 0.1456 | 0.1490 | 0.1549 | 0.1629 |

| Position of upper active layer (nm) | 47 | 51 | 54 |
|---|---|---|---|
| Average emission magnification M | 1.2700 | 1.2685 | 1.2689 |
| Variation in temperature characteristics δ (%/° C) | 0.1725 | 0.1834 | 0.1920 |

Regarding Table 2, Fig. 8 shows a graph in which a horizontal axis represents the position of the upper active layer, and a vertical axis represents the average emission magnification and the variation in temperature characteristics.

As shown in Table 2 and Fig. 8, a result was obtained in which the variation in temperature characteristics was suppressed to 0.2%/°C or lower even when the position of the upper active layer was changed, and the emission magnification was maintained more than 1.2 times. In this simulation, when two active layers were moved in parallel within the light-emitting layer, it was made clear that the variation in temperature characteristics had a small change together with the emission magnification, and that a state where the variation in temperature characteristics is suppressed was able to be maintained.

On the other hand, as shown in Table 2, the variation in temperature characteristics is most suppressed in the arrangement (position of 27 nm of the upper layer active layer) in which two active layers are placed at positions symmetric with respect to the central position within the light-emitting layer. The degree of density of light intensity within the light-emitting layer formed by the upper and lower DBRs is symmetric with respect to the center of the light-emitting layer due to the thickness of the light-emitting layer being λ/2n. Therefore, since the light intensities and the change amounts of two active layers are closest to each other by arranging the active layers symmetrically with respect to the central position within the light-emitting layer, the variation in temperature characteristics is most suppressed in the symmetrical arrangement. That is, the reason is considered to be the arrangement in which the effect of mutual cancellation of changes is largest.

As stated above, it was made clear by Simulation 2 that even when the active layers moved in parallel from the symmetrical arrangement, the relation of mutual cancellation of changes was maintained.

<Simulation 3>

Next, in order to expand a distance of λ/4n which is most excellent in characteristics in Simulation 1, a configuration was examined in which the thickness of the light-emitting layer was increased from 108 nm (=λ/2n) to 216 nm (=λ/n), 324 nm (=3λ/2n), and 432 nm (=2λ/n), and a plurality of active layers were arranged at a position symmetric with respect to the central position A of the light-emitting layer, and under the conditions in which a distance between the active layer and the active layer (distance between the centers of the active layers) is λ/4n.

The LED was configured to have the same configuration as that in Simulation 1, except for the thickness of the light-emitting layer and the number of active layers in the light-emitting layer. Fig. 9 is a schematic cross-sectional view illustrating a light-emitting layer including four active layers 22 in the light-emitting layer having a thickness of λ/n, Fig. 10 is a schematic cross-sectional view illustrating a light-emitting layer including six active layers 22 in the light-emitting layer having a thickness of 3λ/2n, and Fig. 11 is a schematic cross-sectional view illustrating a light-emitting layer including eight active layers 22 in the light-emitting layer having a thickness of 2λ/n. As shown in Figs. 9 to 11, regarding each drawing, from the arrangement conditions of the active layer, a configuration is specified in which each central position of the active layer 22 on the uppermost layer side and the active layer 22 on the lowermost layer side is set to a position of λ/8n vertical from each end of the light-emitting layer, and a plurality of active layer 22 are arranged in a state of maintaining a distance of λ/4n.

The average emission magnifications and the variations in temperature characteristics were each obtained with respect to these arrangements. The results of Simulation 3 are shown in Table 3 in conjunction with the results of the light-emitting layer having a thickness of 108 nm in Simulation 1.

[Table 3]

| Light-emitting layer thickness (nm) | 108 | 216 | 324 | 432 |
|---|---|---|---|---|
| Average emission magnification M | 1.3036 | 1.3211 | 1.334 | 1.3425 |
| Variation in temperature characteristics δ (%/°C) | 0.1446 | 0.1357 | 0.1128 | 0.1219 |

As shown in Table 3, it was made clear that, in any case, the emission magnification was more than 1.3 times, the variation in temperature characteristics was less than 0.2%/°C, and both the enhancement effect and the temperature variation suppression effect were achieved.

From these results, it was made clear that even in the conditions of the increased thickness of the light-emitting layer, the number of active layers and the arrangement thereof were appropriately adjusted, thereby allowing a design capable of enhancing the emitted light intensity to be achieved in a state where the variation in temperature characteristics is suppressed.

That is, it was made clear that a configuration in which a plurality of active layers are arranged at positions symmetric to each other with respect to the center of the light-emitting layer and are arranged so that a distance between the active layer and the active layer is λ/4n was effective irrespective of the thickness of the light-emitting layer.

Meanwhile, on the actual manufacturing of the element, since an increase in the thickness of the light-emitting layer leads to an increase in the cycle time of film formation and an increase in costs involved therein, an unlimited increase in thickness is not desirable.

<Simulation 4>

It is known that in the semiconductor light-emitting element, particularly, the LED, a phenomenon occurs in which an excessive reduction in the thickness of the active layer within the element gives rise to carrier saturation, which makes it difficult to perform the control of the element such as the light emission of portions other than the active layer within the LED. In addition, it is known that in an AlGaAs-based LED, the thickness of the active layer is generally required to be set to approximately 108 nm (=λ/2n) in order to shine the inside of the active layer, and not to emit light in layers other than the DBR layer.

In Simulations 1 to 3 mentioned above, the active layer was set to have a small thickness of 3 nm, but a simulation was performed on a configuration in which the total thickness of the active layers is set to 108 nm.

In Simulation 4, each active layer 22 was set to have a thickness of 27 nm (=λ/8n) in a configuration in which the thickness of the light-emitting layer in Simulation 3 is 216 nm (=λ/n). Fig. 12 shows a schematic cross-sectional view illustrating a light-emitting layer in this simulation. Since each of four active layers 22 has a thickness of 27 nm (=λ/8n), the thickness of the entire active layer is 108 nm (=λ/2n).

Regarding the configuration, after the average emission magnification and the variation in temperature characteristics were each obtained on the basis of the above simulation method, the average emission magnification was 1.3212 times, and the variation in temperature characteristics was 0.1369%/°C. These values are substantially the same as those in a case of the light-emitting layer having a thickness of 216 nm in Simulation 3 (see Table 3).

This result can be described by adapting the result of Simulation 3 to the result of a small change in characteristics due to parallel movement in a state where λ/4n shown in Simulation 2 is maintained. That is, for each fine portion in the active layer having a thickness of 27 nm, the active layer corresponding to a position of (λ/4n) is present, and thus the effect of uniform light intensity due to mutual cancellation of changes is exerted on each fine portion. It was made clear by Simulation 4 that even when the thickness of the active layer increased, the emission magnification was improved in a state where the variation in temperature characteristics is suppressed.

<Simulation 5>

Further, a case where the light-emitting layer has a multi-quantum well structure was examined. The advantage of the quantum well structure includes the capability to prevent carrier saturation because the control of the active layer position within the light-emitting layer is facilitated, the emission variation within the active layer is not likely to occur due to the small thickness of the active layer, and the thickness of the entire active layer can be increased by multiplexing.

In this examination, a light-emitting layer of a quantum well structure with twelve active layers 22, each having a thickness of 9 nm (=λ/24n), was used. Fig. 13 shows a schematic cross-sectional view illustrating the light-emitting layer used in this simulation. As shown in Fig. 13, the active layers symmetric with respect to a central position A of the light-emitting layer were arranged, and the light-emitting layer in which the active layers are arranged at equal intervals was examined. Inactive layers arranged between the active layers were all set to have a thickness of 9 nm, and inactive layers arranged at both ends of the light-emitting layer were all set to have a thickness of 4.5 nm. A structure is used in which a separate active layer is necessarily arranged at a distance of λ/4n from any of the active layers.

In Simulation 5, only the inside of the light-emitting layer was changed in a configuration in which the thickness of the light-emitting layer in Simulation 3 is 216 nm (=λ/n)

After the average emission magnification and the variation in temperature characteristics in this case were each obtained by the above simulation method, the emission magnification was 1.3490 times, and the variation in temperature characteristics was 0.1503 (%/°C).

In this manner, it was possible to obtain a structure in which both the suppression of the variation in temperature characteristics and the increase in emitted light intensity are achieved even in the complex multi-quantum well structure.

As stated above, a structure of the light-emitting layer capable of suppressing a variation temperature characteristics while increasing the emitted light intensity was found by Simulations 1 to 5. Meanwhile, each of the simulations is performed on an AlGaAs-based semiconductor light-emitting element, but it is considered that the tendency of the variation in temperature characteristics or the distance dependency on the degree of emission enhancement shows the same tendency regardless of compositions.

Hereinafter, examples of the present invention and comparative examples which fall outside the scope of the claims will be described.

[Example 1]

An LED was manufactured which has a structure in which four active layers are included in the light-emitting layer having a thickness of λ/n shown in Fig. 12 regarding Simulation 4. The specific layer configuration of the LED manufactured in Example 1 is shown in a table of Fig. 14. As shown in the table of Fig. 14, a design was performed in which the active layer was formed as $Al_{0.128}Ga_{0.972}As$ and the inactive layer was formed as $Al_{0.23}Ga_{0.77}As$ from the relation of a bandgap. The thickness of the light-emitting layer is 216 nm (=λ/n), and each active layer is 27 nm (=λ/8n).

Each layer was sequentially formed on a GaAs wafer by a MOCVD method. Elements were formed by dicing the wafer, and five samples cut out from positions 1 to 5 shown in the plan view of Fig. 3 were obtained.

For each of these samples 1 to 5, the emission magnification and the temperature characteristics were inspected. The results are shown in Table 4. Meanwhile, the emission magnification herein refers to light intensity when light intensity obtained by a simulation with respect to a case where the DBR layer is not included is set to 1.

Table 4]

| Sample | Sample 1 | Sample 2 | Sample 3 | Sample 4 | Sample 5 |
|---|---|---|---|---|---|

As shown in Table 4, the samples 1 to 5 are different from each other in emission magnification and temperature characteristics. It is considered that this is attributed to the different film thickness in each sample. The average emission magnification M for the samples 1 to 5 was 1.33 times, and the variation in temperature characteristics δ was 0.191 (%/°C).

In the element of the present example, the variation in temperature characteristics δ satisfies less than 0.2%/°C. The variation was able to be kept sufficiently small and to be achieved with an increase in emitted light intensity.

Meanwhile, compared with the result of Simulation 4, the emission magnification is almost as predicted, while the variation in temperature characteristics is large. It is considered that this is because non-uniform emission within the active layer occurs due to the active layer within the light-emitting layer having a thickness of 27 nm.

[Comparative Example 1]

As Comparative Example 1, which falls outside the scope of the claims, structures other than the light-emitting layer were all set to be the same as those in Example 1, and an LED element was manufactured in which the arrangement of the active layers within the light-emitting layer was changed. The detailed layer configuration thereof is shown in a table of Fig. 15, and the enlarged schematic diagram of the light-emitting layer is shown together. As compared with the arrangement of the active layers within the light-emitting layer of Example 1, a centrally symmetrical arrangement is used in which a distance between first and second active layers is increased, and a distance between second and third active layers is reduced.

Similarly to Example 1, the emission magnification and the temperature characteristics were measured with respect to five samples cut out from one wafer. The results are shown in Table 5.

[Table 5]

| Sample | Sample 1 | Sample 2 | Sample 3 | Sample 4 | Sample 5 |
|---|---|---|---|---|---|
| Emission magnification | 1.27 | 1.02 | 0.89 | 0.91 | 1.07 |
| Temperature characteristics (%/ ° C) | -0.796 | -0.417 | 0.053 | 0.528 | 0.868 |

As shown in Table 5, the emission magnification is low in general, and the numerical values of the temperature characteristics are also large. The average emission magnification M is 1.03 times, and the variation in temperature characteristics δ is 1.664%/°C.

[Comparative Example 2]

As Comparative Example 2, which falls outside the scope of the claims, structures other than the light-emitting layer were all set to be the same as those in Example 1, and an LED element was manufactured in which the arrangement of the active layers within the light-emitting layer was changed. The detailed layer configuration thereof is shown in a table of Fig. 16, and the enlarged schematic diagram of the light-emitting layer is shown together. As compared to the arrangement of the active layers within the light-emitting layer of Example 1, a centrally symmetrical arrangement is used in which a distance between first and second active layers is reduced, and a distance between second and third active layers is increased.

Similarly to Example 1, the emission magnification and the temperature characteristics were measured with respect to five samples cut out from one wafer. The results are shown in Table 6.

[Table 6]

| Sample | Sample 1 | Sample 2 | Sample 3 | Sample 4 | Sample 5 |
|---|---|---|---|---|---|
| Emission magnification | 1.51 | 1.77 | 1.86 | 1.70 | 1.39 |
| Temperature characteristics (%/°C) | 0.582 | 0.207 | -0.363 | -0.686 | -0.626 |

As shown in Table 6, the emission magnification is high in general, but the numerical values of the temperature characteristics are large. The average emission magnification M is 1.64 times, and the variation in temperature characteristics δ is 1.268%/°C.

The average emission magnifications and the variations in temperature characteristics in Example 1, Comparative Example 1 and Comparative Example 2 are shown in Table 7.

[Table 7]

| | Average emission magnification M (times) | Variation in temperature characteristics δ (%/°C) |
|---|---|---|
| Example 1 | 1.33 | 0.192 |
| Comparative Example 1 | 1.03 | 1.664 |
| Comparative Example 2 | 1.64 | 1.269 |

As in Example 1, it is made clear that the variation in temperature characteristics can be suppressed by appropriately arranging the active layers.

On the other hand, in Comparative Example 1, as compared with Example 1, the emission magnification is considerably low, and the variation in temperature characteristics is large. It is considered that the light intensity increase effect and the effect of the variation in temperature characteristics suppression are not obtained due to the active layers not being appropriately arranged within the light-emitting layer. In addition, in Comparative Example 2, as compared with Example 1, the average emission magnification is high, and the variation in temperature characteristics is large. As is the case with Comparative Example 1, it is considered that the suppression effect of the variation in temperature characteristics is not obtained due to the active layers not being appropriately arranged within the light-emitting layer.

[Reference Example]

As a reference example, which falls outside the scope of the claims, structures other than the light-emitting layer were all set to be the same as those in Example 1, and an LED was manufactured in which a thin active layer having a thickness of 3 nm was formed within the light-emitting layer. The detailed layer configuration thereof is shown in a table of Fig. 17. The light-emitting layer of this reference example has a structure of the enlarged schematic diagram of Fig. 9 described in Simulation 2.

Similarly to Example 1, the emission magnification and the temperature characteristics were measured with respect to five samples cut out from one wafer. As a result, the average emission magnification M was 1.20 times, and the variation in temperature characteristics δ was 2.064 (%/°C). Since the total thickness of the active layers is 12 nm and excessively small, it is considered that the variation in temperature characteristics is considerably large due to carrier saturation, and light emission of not only the inactive layer within the light-emitting layer but also $Al_{0.3}Ga_{0.7}As$ within the DBR, or the like. It was made clear that the thickness of the LED was required to be the same as or larger than the level of the total thickness of the active layers.

[Example 2]

An LED was manufactured which includes the light-emitting layer having the multi-quantum well structure shown in Fig. 13 regarding Simulation 5. The specific layer configuration of the LED manufactured in Example 2 is shown in a table of Fig. 18. As shown in the table of Fig. 18, in the present example, twelve quantum well active layers, each having a thickness of 9 nm, are laminated with the inactive layer of 9 nm interposed therebetween.

Similarly to Example 1, the emission magnification and the temperature characteristics were measured with respect to five samples cut out from one wafer. The results are shown in Table 8.

[Table 8]

| Sample | Sample 1 | Sample 2 | Sample 3 | Sample 4 | Sample 5 |
|---|---|---|---|---|---|
| Emission magnification | 1.38 | 1.38 | 1.35 | 1.29 | 1.26 |
| Temperature characteristics (%/°C) | 0.000 | -0.056 | -0.112 | -0.056 | 0.038 |

The average emission magnification M for samples 1 to 5 was 1.33 times, and the variation in temperature characteristics δ was 0.150 (%/°C). These are substantially the same values as the results of Simulation 5. It is considered that emission within the active layer becomes uniform by adopting emission using a quantum well, and ideal results according to the simulation can be obtained.

Meanwhile, as a result of the inspection of the average emission magnification and the variation in temperature characteristics, similarly to Example 1, with respect to an LED which has the same light-emitting layer as that in Example 1, but has a different lower DBR layer and a different upper DBR layer, the variation in temperature characteristics was able to be suppressed even when the DBR layer having a different configuration was included.

Meanwhile, in the present example, although a MOCVD method has been used as a method of forming a semiconductor film, a method of manufacturing a semiconductor element according to the present invention is not limited thereto, but other methods (MBE method and the like) may be used, and the same effect is exhibited regardless of the film formation method.

The semiconductor light-emitting element of the present invention uses a plurality of LEDs, manufactured on the same wafer, which have variations in film thicknesses, and thus an extremely large effect is exhibited when the semiconductor light-emitting element is applied to an LED array exposure apparatus or the like which is required for the light intensity to be made uniform.

## Claims

1. A semiconductor light-emitting element (1) that outputs emitted light having a predetermined emission peak wavelength, comprising at least:

   a substrate (10);
   a lower distributed Bragg reflective layer (12, 30) provided on the substrate (10);
   and a light-emitting layer (20) provided on the lower distributed Bragg reflective layer (12, 30); wherein the light-emitting layer (20) has a structure in which one or more sets of two active layers (22) arranged at a distance of (1+2m) $\lambda/4n$ with a variation of $\pm$ 10 % are included in an inactive layer (22), $\lambda$ is the emission peak wavelength, n is a refractive index of the light-emitting layer (20), and m is an integer of 0 or greater, wherein the distance between two active layers (22) is defined by a mutual distance between their centres in a thickness direction, wherein an antireflective layer for the emitted light is included on the light-emitting layer.

2. The semiconductor light-emitting element (1) according to claim 1, wherein a thickness of the light-emitting layer (20) is $k\lambda/2n$, $\lambda$ is the emission peak wavelength, n is a refractive index of the light-emitting layer (20), and k is an integer of 1 or greater.

3. The semiconductor light-emitting element (1) according to claim 1 or 2, wherein the integer m is 0.

4. The semiconductor light-emitting element (1) according to any one of claims 1 to 3, wherein the active layers (22) are arranged at positions which are vertically symmetric with respect to a central position of the light-emitting layer (20) in a thickness direction.

5. The semiconductor light-emitting element (1) according to any one of claims 1 to 4, wherein a thickness of each of the active layers (22) is equal to or less than 10 nm.

6. The semiconductor light-emitting element (1) according to any one of claims 1 to 5, wherein a total thickness of the active layers (22) included in the light-emitting layer (20) is equal to or greater than $\lambda/4n$, and the semiconductor light-emitting element (20) functions as a light-emitting diode.

7. The semiconductor light-emitting element (1) according to any one of claims 1 to 6, wherein an upper distributed Bragg reflective layer (16) is included on the light-emitting layer (20).

8. The semiconductor light-emitting element (1) according to any one of claims 1 to 7, wherein at least one phase change layer (33) having a thickness of $j\cdot\lambda/2n$ is included in the lower distributed Bragg reflective layer (30), n is a refractive index of the phase change layer, and j is an integer of 1 or greater.

## Patentansprüche

1. Halbleiter-Lichtemittierungselement (1), welches emittiertes Licht mit einer vorbestimmten Emissions-Spitzenwellenlänge ausgibt, mindestens umfassend:

   ein Substrat (10);

eine untere Bragg-Spiegelschicht (12, 30), die auf dem Substrat (10) vorgesehen ist;
eine Lichtemissionsschicht (20) auf der unteren Bragg-Spiegelschicht (12, 30);
wobei die Lichtemissionsschicht (20) eine Struktur besitzt, bei der ein oder mehrere Sätze von zwei aktiven Schichten (22) in einem Abstand von (1+2 m) λ/4n mit einer Schwankung von ±10% in einer inaktiven Schicht (22) angeordnet sind, wobei λ die Emissions-Spitzenwellenlänge ist, n ein Brechungsindex der Lichtemissionsschicht (20) ist, und m eine natürliche Zahl von 0 oder größer ist, wobei der Abstand zwischen zwei aktiven Schichten (22) definiert ist durch einen gegenseitigen Abstand ihrer Mitten in einer Dickenrichtung, wobei eine Antireflexionsschicht für das Emissionslicht in der Lichtemissionsschicht enthalten ist.

**2.** Halbleiter-Lichtemissionselement (1) nach Anspruch 1, bei dem eine Dicke der Lichtemissionsschicht (20) kλ/2n beträgt, wobei λ die Emissions-Spitzenwellenlänge ist, n ein Brechungsindex der Lichtemissionsschicht (20) und k eine natürliche Zahl 1 oder größer ist.

**3.** Halbleiter-Lichtemissionselement (1) nach Anspruch 1 oder 2, bei dem die natürliche Zahl m 0 beträgt.

**4.** Halbleiter-Lichtemissionselement (1) nach einem der Ansprüche 1 bis 3, bei dem die aktiven Schichten (22) an Stellen angeordnet sind, die in Bezug auf eine Zentralposition der Lichtemissionsschicht (20) in einer Dickenrichtung vertikal symmetrisch sind.

**5.** Halbleiter-Lichtemissionselement (1) nach einem der Ansprüche 1 bis 4, bei dem eine Dicke jeder der aktiven Schichten (22) gleich oder kleiner 10 nm ist.

**6.** Halbleiter-Lichtemissionselement (1) nach einem der Ansprüche 1 bis 5, bei dem eine Gesamtdicke der aktiven Schichten (22) in der Lichtemissionsschicht (20) gleich oder größer als das λ/4n ist, und das Halbleiter-Lichtemissionselement (20) als Leuchtdiode fungiert.

**7.** Halbleiter-Lichtemissionselement (1) nach einem der Ansprüche 1 bis 6, bei dem eine obere Bragg-Spiegelschicht (16) in der Lichtemissionsschicht (20) enthalten ist.

**8.** Halbleiter-Lichtemissionselement (1) nach einem der Ansprüche 1 bis 7, bei dem
mindestens eine Phasenänderungsschicht (33) mit einer Dicke von j·λ/2n in der unteren Bragg-Spiegelschicht (30) enthalten ist, wobei
n ein Brechungsindex der Phasenänderungsschicht und j eine natürliche Zahl von 1 oder größer ist.

## Revendications

**1.** Élément luminescent semi-conducteur (1), lequel produit une lumière émise présentant une longueur d'onde de crête d'émission prédéterminée, comprenant au moins :

un substrat (10) ;
une couche à réflexion de Bragg à distribution plus basse (12, 30) prévue sur le substrat (10), et
une couche luminescente (20) prévue sur la couche à réflexion de Bragg à distribution plus faible (12, 30),
dans lequel la couche luminescente (20) présente une structure où un ou plusieurs jeux de deux couches actives (22) agencées à une distance de (1+2m)λ/4n avec une variation de ± 10% sont incluses dans une couche inactive (22), λ est la longueur d'onde de crête d'émission, n est un indice de réfraction de la couche luminescente (20), et m est un entier supérieur ou égal à 0, dans lequel la distance entre deux couches actives (22) est définie par une distance mutuelle entre leurs centres dans une direction d'épaisseur, et dans lequel une couche antireflet pour la lumière émise est incluse sur la couche luminescente.

**2.** Élément luminescent semi-conducteur (1) selon la revendication 1, dans lequel une épaisseur de la couche luminescente (20) est kλ/2n, λ est la longueur d'onde de crête d'émission, n est un indice de réfraction de la couche luminescente (20), et k est un entier supérieur ou égal à 1.

**3.** Élément luminescent semi-conducteur (1) selon la revendication 1 ou 2, dans lequel l'entier m est égal à 0.

**4.** Élément luminescent semi-conducteur (1) selon l'une quelconque des revendications 1 à 3, dans lequel les couches actives (22) sont agencées en des positions, lesquelles présentant une symétrie verticale par rapport à une position centrale de la couche luminescente (20) dans une direction d'épaisseur.

5. Élément luminescent semi-conducteur (1) selon l'une quelconque des revendications 1 à 4, dans lequel une épaisseur de chacune des couches actives (22) est inférieure ou égale à 10 nm.

6. Élément luminescent semi-conducteur (1) selon l'une quelconque des revendications 1 à 5, dans lequel une épaisseur totale des couches actives (22) incluses dans la couche luminescente (20) est supérieure ou égale à $\lambda/4n$, et l'élément luminescent semi-conducteur (20) fonctionne comme une diode luminescente.

7. Élément luminescent semi-conducteur (1) selon l'une quelconque des revendications 1 à 6, dans lequel une couche à réflexion de Bragg à distribution plus haute (16) est incluse sur la couche luminescente (20).

8. Élément luminescent semi-conducteur (1) selon l'une quelconque des revendications 1 à 7, dans lequel au moins une couche à changement de phase (33) présentant une épaisseur de $j\cdot\lambda/2n$ est incluse dans la couche à réflexion de Bragg à distribution plus basse (30) ; n est un indice de réfraction de la couche à changement de phase, et j est un entier supérieur ou égal à 1.

FIG. 1A

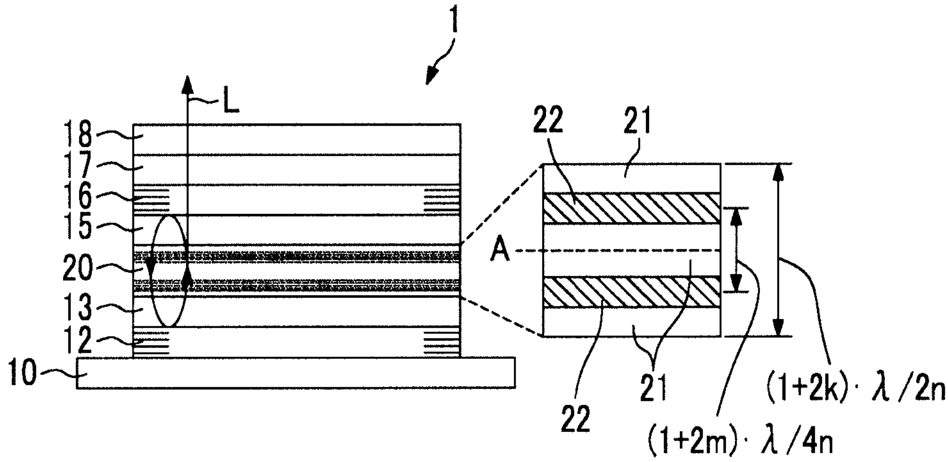

FIG. 1B

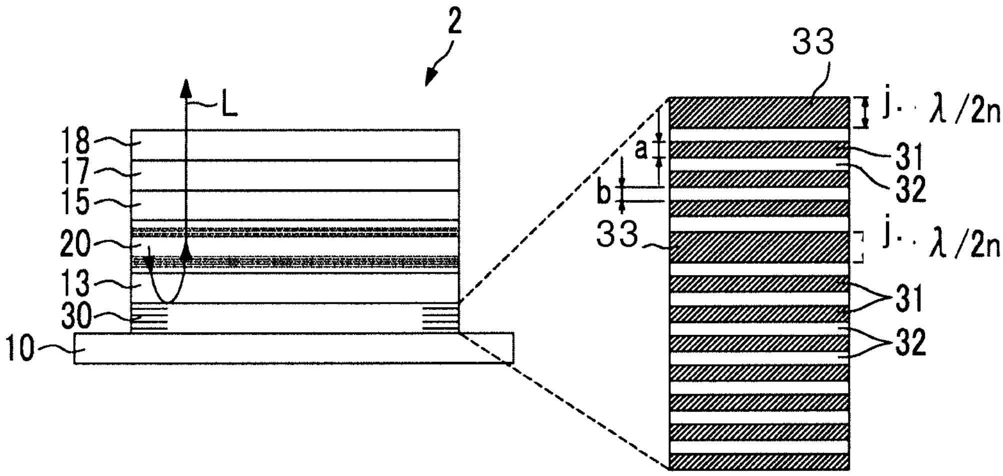

FIG. 2

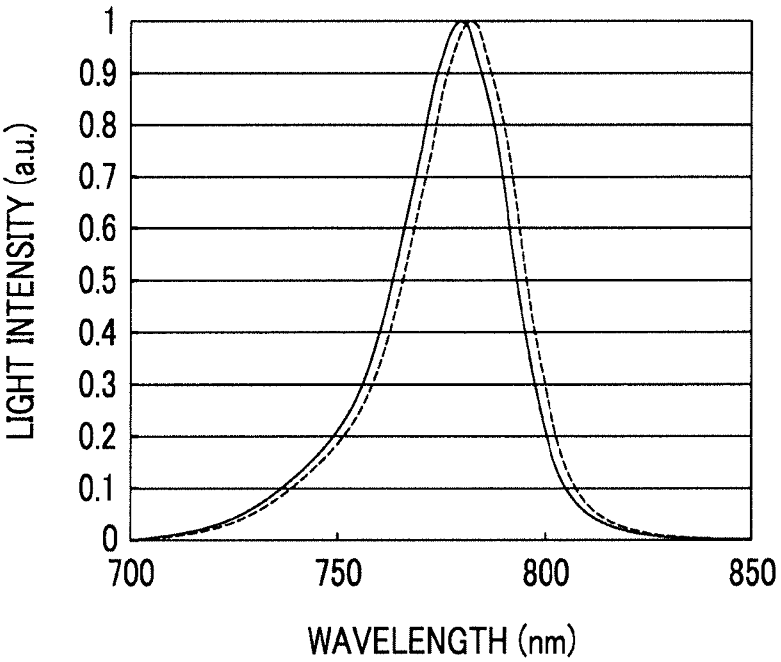
1
0.9
0.8
0.7
0.6
0.5
0.4
0.3
0.2
0.1
0
LIGHT INTENSITY (a.u.)
700
750
800
850
WAVELENGTH (nm)

FIG. 3

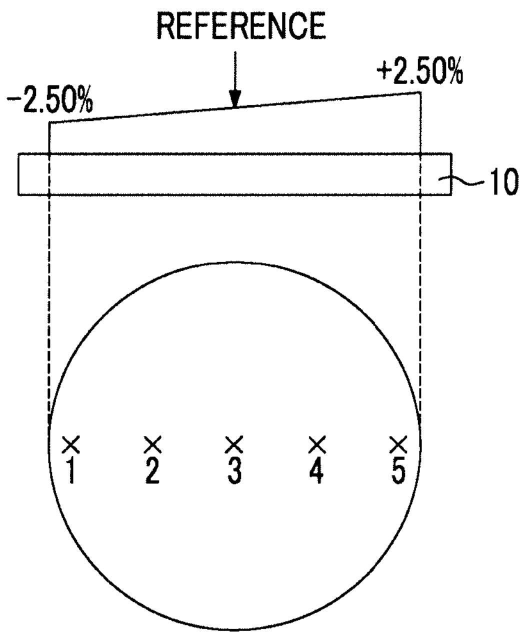

# FIG. 4

| | Material | REFRACTIVE INDEX(@780nm) | thickness(μm) |
|---|---|---|---|
| | air | 1 | |
| 18 | SiO2 | 1.454 | 0.67 |
| 17 | contact | 3.693 | 0.03 |
| | Al900 | 3.087 | 0.008 |
| 16 | Al300 | 3.455 | 0.056 |
| | Al900 | 3.087 | 0.072 |
| | Al300 | 3.455 | 0.056 |
| | Al900 | 3.087 | 0.072 |
| | Al300 | 3.455 | 0.056 |
| | Al900 | 3.087 | 0.072 |
| | Al300 | 3.455 | 0.056 |
| | Al900 | 3.087 | 0.072 |
| | Al300 | 3.455 | 0.056 |
| | Al900 | 3.087 | 0.008 |
| 15 | Al280 | 3.472 | 0.3951 |
| 20 | active | 3.612 | 0.108 |
| 13 | Al280 | 3.472 | 0.2822 |
| 12 | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| | Al900 | 3.087 | 0.0632 |
| | Al300 | 3.455 | 0.0564 |
| 10 | GaAs SUBSTRATE | 3.693 | |

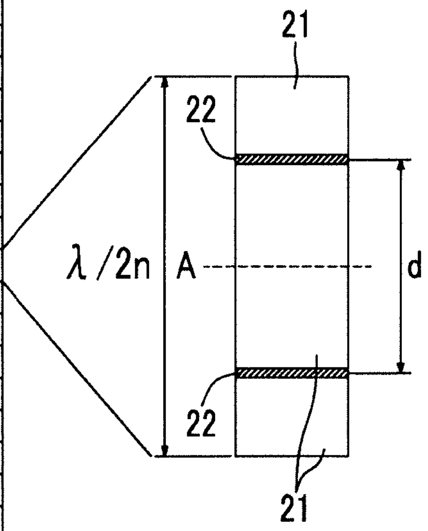

FIG. 5

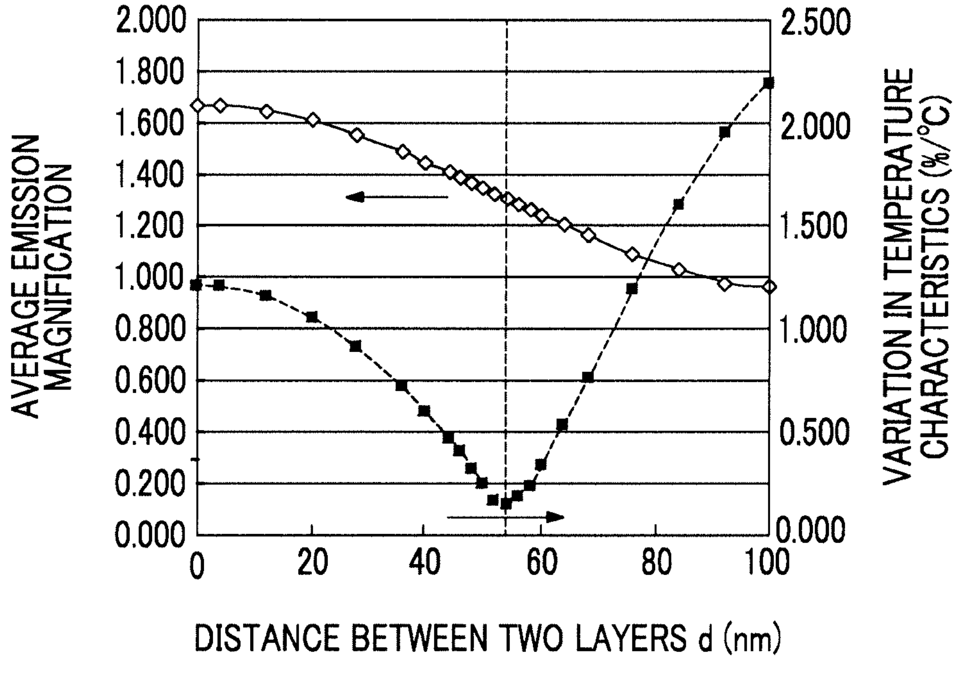

AVERAGE EMISSION MAGNIFICATION
VARIATION IN TEMPERATURE CHARACTERISTICS (%/°C)
2.000
1.800
1.600
1.400
1.200
1.000
0.800
0.600
0.400
0.200
0.000
2.500
2.000
1.500
1.000
0.500
0.000
0
20
40
60
80
100
DISTANCE BETWEEN TWO LAYERS d (nm)

FIG. 6A

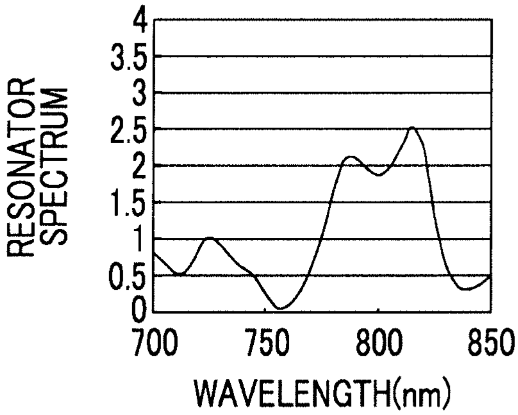


FIG. 6B

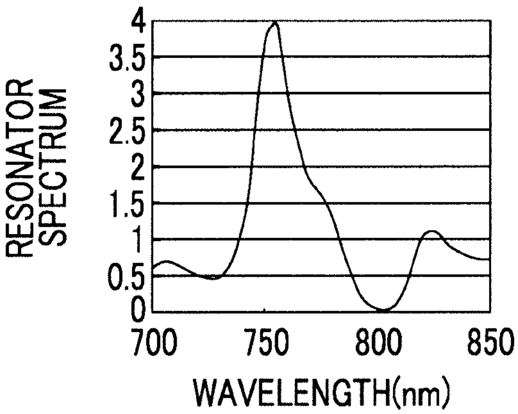


FIG. 6C

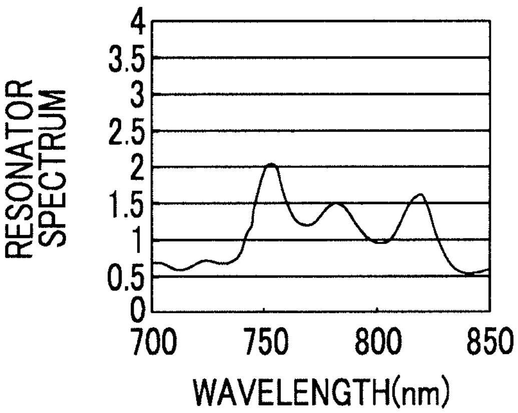

FIG. 7

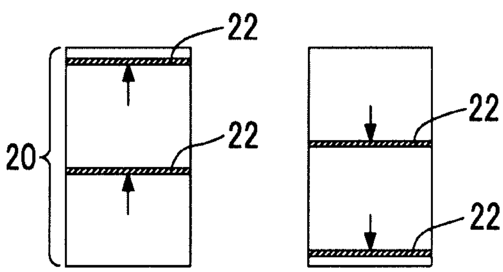

FIG. 8

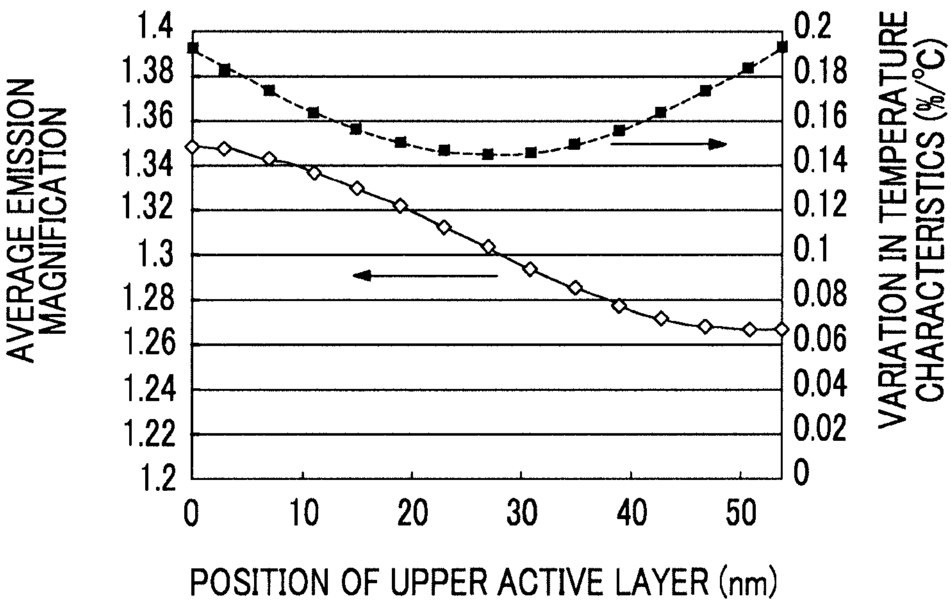
AVERAGE EMISSION MAGNIFICATION
1.4
1.38
1.36
1.34
1.32
1.3
1.28
1.26
1.24
1.22
1.2
0
10
20
30
40
50
POSITION OF UPPER ACTIVE LAYER (nm)
0.2
0.18
0.16
0.14
0.12
0.1
0.08
0.06
0.04
0.02
0
VARIATION IN TEMPERATURE CHARACTERISTICS (%/°C)

FIG. 9

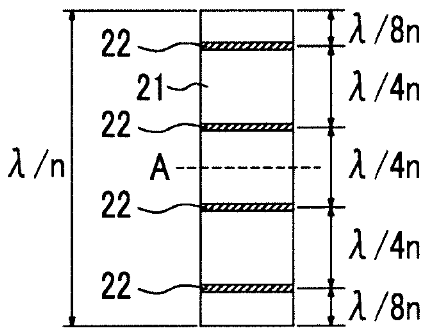

FIG. 10

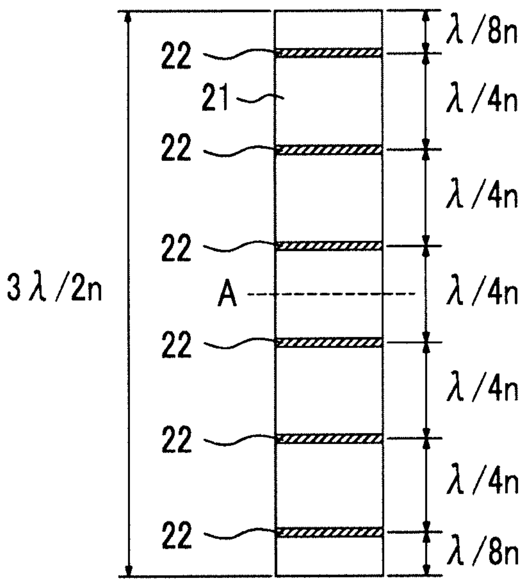

FIG. 11

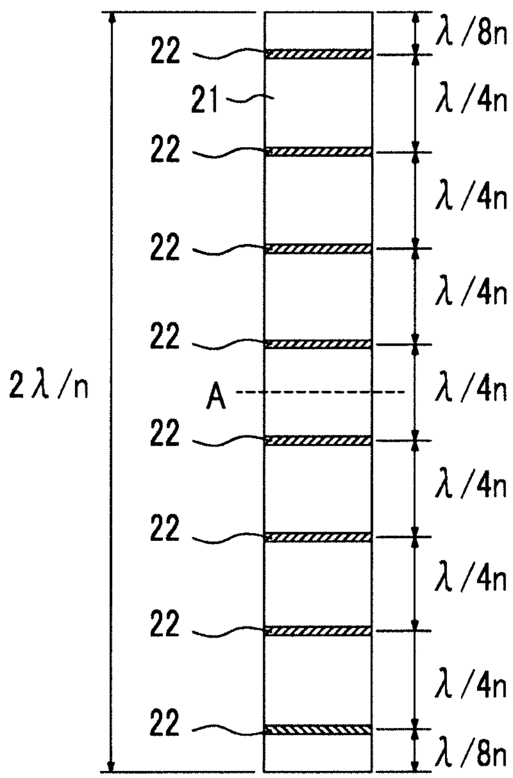

FIG. 12

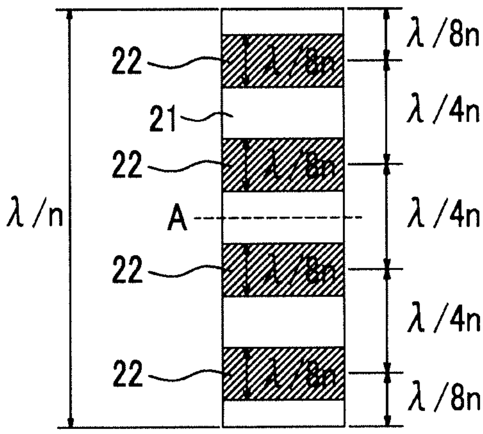

FIG. 13

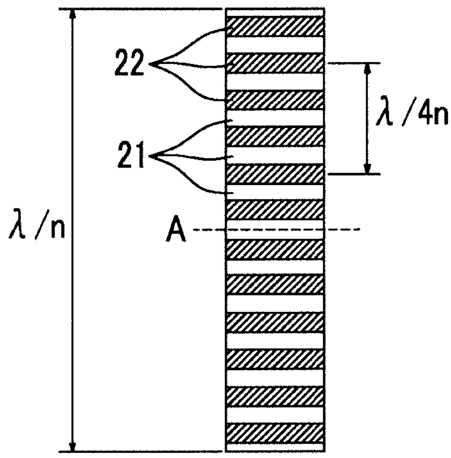

FIG. 14

| | Material | thickness($\mu$m) |
|---|---|---|
| | air | |
| 18 | SiO2 | 0.67 |
| 17 | contact | 0.03 |
| | n-Al0.9Ga0.1As | 0.008 |
| | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.072 |
| 16 | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.008 |
| 15 | n-Al0.28Ga0.72As | 0.3951 |
| | Al0.23Ga0.77As | 0.0135 |
| | Al0.128Ga0.872As | 0.027 |
| | Al0.23Ga0.77As | 0.027 |
| | Al0.128Ga0.872As | 0.027 |
| 20 | Al0.23Ga0.77As | 0.027 |
| | Al0.128Ga0.872As | 0.027 |
| | Al0.23Ga0.77As | 0.027 |
| | Al0.128Ga0.872As | 0.027 |
| | Al0.23Ga0.77As | 0.0135 |
| 13 | p-Al0.28Ga0.72As | 0.2822 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| 12 | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| 10 | GaAs SUBSTRATE | |

# FIG. 15

| | Material | thickness($\mu$m) |
|---|---|---|
| | air | |
| 18 | SiO2 | 0.67 |
| 17 | contact | 0.03 |
| | n-Al0.9Ga0.1As | 0.008 |
| | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.072 |
| 16 | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.008 |
| 15 | n-Al0.28Ga0.72As | 0.3951 |
| | Al0.23Ga0.77As | 0.0025 |
| | Al0.128Ga0.872As | 0.027 |
| | Al0.23Ga0.77As | 0.049 |
| | Al0.128Ga0.872As | 0.027 |
| 20 | Al0.23Ga0.77As | 0.005 |
| | Al0.128Ga0.872As | 0.027 |
| | Al0.23Ga0.77As | 0.049 |
| | Al0.128Ga0.872As | 0.027 |
| | Al0.23Ga0.77As | 0.0025 |
| 13 | p-Al0.28Ga0.72As | 0.2822 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| 12 | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| 10 | GaAs SUBSTRATE | |

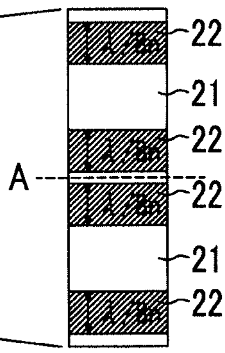

# FIG. 16

| | Material | thickness(μm) |
|---|---|---|
| | air | |
| 18 | SiO2 | 0.67 |
| 17 | contact | 0.03 |
| | n-Al0.9Ga0.1As | 0.008 |
| 16 | n-Al0.3Ga0.7As | 0.056 |
| 16 | n-Al0.9Ga0.1As | 0.072 |
| 16 | n-Al0.3Ga0.7As | 0.056 |
| 16 | n-Al0.9Ga0.1As | 0.072 |
| 16 | n-Al0.3Ga0.7As | 0.056 |
| 16 | n-Al0.9Ga0.1As | 0.072 |
| 16 | n-Al0.3Ga0.7As | 0.056 |
| 16 | n-Al0.9Ga0.1As | 0.072 |
| 16 | n-Al0.3Ga0.7As | 0.056 |
| | n-Al0.9Ga0.1As | 0.008 |
| 15 | n-Al0.28Ga0.72As | 0.3951 |
| 20 | Al0.23Ga0.77As | 0.0245 |
| 20 | Al0.128Ga0.872As | 0.027 |
| 20 | Al0.23Ga0.77As | 0.005 |
| 20 | Al0.128Ga0.872As | 0.027 |
| 20 | Al0.23Ga0.77As | 0.049 |
| 20 | Al0.128Ga0.872As | 0.027 |
| 20 | Al0.23Ga0.77As | 0.005 |
| 20 | Al0.128Ga0.872As | 0.027 |
| 20 | Al0.23Ga0.77As | 0.0245 |
| 13 | p-Al0.28Ga0.72As | 0.2822 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 10 | GaAs SUBSTRATE | |

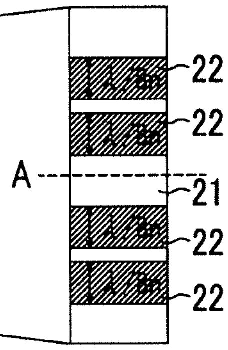

FIG. 17

| | Material | thickness(μm) |
|---|---|---|
| | air | |
| 18 | SiO2 | 0.67 |
| 17 | contact | 0.03 |
| | n-Al0.9Ga0.1As | 0.008 |
| | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.072 |
| 16 | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.072 |
| | n-Al0.3Ga0.7As | 0.056 |
| | n-Al0.9Ga0.1As | 0.008 |
| 15 | n-Al0.28Ga0.72As | 0.3951 |
| | Al0.23Ga0.77As | 0.0255 |
| | Al0.128Ga0.872As | 0.003 |
| | Al0.23Ga0.77As | 0.051 |
| | Al0.128Ga0.872As | 0.003 |
| 20 | Al0.23Ga0.77As | 0.051 |
| | Al0.128Ga0.872As | 0.003 |
| | Al0.23Ga0.77As | 0.051 |
| | Al0.128Ga0.872As | 0.003 |
| | Al0.23Ga0.77As | 0.0255 |
| 13 | p-Al0.28Ga0.72As | 0.2822 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| 12 | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| | p-Al0.9Ga0.1As | 0.0632 |
| | p-Al0.3Ga0.7As | 0.0564 |
| 10 | GaAs SUBSTRATE | |

# FIG. 18

| Ref. | Material | thickness(μm) |
|---|---|---|
| | air | |
| 18 | SiO2 | 0.67 |
| 17 | contact | 0.03 |
| | n-Al0.9Ga0.1As | 0.008 |
| 16 | n-Al0.3Ga0.7As | 0.056 |
| 16 | n-Al0.9Ga0.1As | 0.072 |
| 16 | n-Al0.3Ga0.7As | 0.056 |
| 16 | n-Al0.9Ga0.1As | 0.072 |
| 16 | n-Al0.3Ga0.7As | 0.056 |
| 16 | n-Al0.9Ga0.1As | 0.072 |
| 16 | n-Al0.3Ga0.7As | 0.056 |
| 16 | n-Al0.9Ga0.1As | 0.072 |
| 16 | n-Al0.3Ga0.7As | 0.056 |
| | n-Al0.9Ga0.1As | 0.008 |
| 15 | n-Al0.28Ga0.72As | 0.3951 |
| 20 | Al0.23Ga0.77As | 0.0045 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.009 |
| 20 | Al0.128Ga0.872As | 0.009 |
| 20 | Al0.23Ga0.77As | 0.0045 |

| Ref. | Material | thickness(μm) |
|---|---|---|
| 13 | p-Al0.28Ga0.72As | 0.2822 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 12 | p-Al0.9Ga0.1As | 0.0632 |
| 12 | p-Al0.3Ga0.7As | 0.0564 |
| 10 | GaAs SUBSTRATE | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2010224892 A1
- JP 6196681 A
- JP H6196681 A
- JP 2009070929 A
- JP 2003332615 A
- JP 2010219220 A

### Non-patent literature cited in the description

- **ZHANG et al.** Low threshold lasing of GaN-based vertical cavity surface emitting lasers with an asymmetric coupled quantum well active region. *applied physics letter,* 2008, vol. 93, 191118